# EUROPÄISCHE PATENTSCHRIFT

(11) **EP 0 922 983 B1**
(45) Veröffentlichungstag und Bekanntmachung des Hinweises auf die Patenterteilung: **24.08.2005**
(21) Anmeldenummer: 98121444.8
(22) Anmeldetag: 11.11.1998
(51) Int. Cl.: G02B 7/02, C03C 27/04

(54) **VUV-beständige Verbindungstechnik für Linsen und Fassungen**
VUV-resistant connection technique for lenses and mounts
Technique de connexion pour des lentilles et des montures résistantes aux rayons VUV

(30) Priorität: 12.12.1997 DE 19755356
(43) Veröffentlichungstag der Anmeldung: 16.06.1999
(73) Patentinhaber: Carl Zeiss SMT AG, 73446 Oberkochen (DE)
(72) Erfinder: Holderer, Hubert, 89551 Königsbronn (DE); Christ, Johannes, 88454 Schweinhausen (DE)
(74) Vertreter: Müller-Rissmann, Werner Albrecht

(56) Entgegenhaltungen:
- EP-A- 0 170 513
- EP-A- 0 568 073
- EP-A- 0 761 623
- DE-A- 2 900 356
- GB-A- 1 468 973
- GB-A- 2 070 487
- US-A- 4 089 102
- PATENT ABSTRACTS OF JAPAN vol. 010, no. 369 (P-525), 10. Dezember 1986 & JP 61 162011 A (FUJITSU LTD), 22. Juli 1986

## Beschreibung

Die Erfindung betrifft eine optische Baugruppe, bestehend aus einem optischen Element aus transparentem Material und einer Fassung nach dem Oberbegriff des Anspruchs 1.

Auch betrifft sie ein Verfahren zum Befestigen eines optischen Elements aus nichtmetallischem, insbesondere transparentem Material, insbesondere aus Quarzglas oder Kalziumfluorid, an einer Fassung nach dem Oberbegriff des Anspruchs 10.

Als Fassung im Sinne der Erfindung ist insbesondere jedes selbst nicht lichtführende Bauelement zu verstehen, das geeignet ist ein oder mehrere optische Bauelemente mechanisch zu fixieren und zu Baugruppen oder optischen Systemen zu verbinden bzw. in Wirkverbindung zu bringen oder mit Stellelementen in Wirkverbindung zu bringen.

Weiter betrifft sie UV-optische Systeme, Mikroskope und Projektionsbelichtungsanlagen nach den Ansprüchen 7 bis 9.

Fügetechniken zur Verbindung von Linsen, Prismen, Planplatten und Spiegeln mit Fassungen sind in großer Zahl bekannt.

Wichtig ist das Kitten, da besonders geringe Verspannungen des optischen Teils erzielt werden. Moderne Formen verwenden UVhärtende Kleber. Die organischen Kleber zeigen jedoch bei Bestrahlung mit Wellenlängen unterhalb der Hg-I-Linie deutliche Strahlungsschäden, so daß sie besonders für DUV-Projektionsbelichtungsanlagen mit 193 nm Excimer-Laser kaum mehr brauchbar sind.

Klassische formschlüssige Verbindungen wie Bördelung oder Vorsatzringe erzeugen für dieses Anwendungsgebiet zu hohe Spannungen im optischen Material.

Aus der EP 0 761 623 u.a. sind Ringverlötungen von Glas und dergleichen mit Fassungen bekannt. Diese dienen primär als gasdichte Anschlüsse von Fenstern für Laser, Vakuumkammern und dergleichen. Es wird regelmäßig bei hohen Temperaturen im Hartlötbereich bei ca. 400° C und mehr gearbeitet. Solche Hochtemperturbehandlung ist für fertige Präzisionsoptik mit Antireflexschichten usw. ausgeschlossen.

Aus der nicht vorveröffentlichten Patentanmeldung DE 197 35 760.1 der Anmelderin ist eine für optische Präzisionsfassungen geeignete Löttechnik mit Haftschicht auf Quarz oder Kalziumfluorid bekannt, die eine stoffschlüssige Verbindung lokaler Art mit Stegen oder Laschen vorsieht. Eine formschlüssige Fassung mit Lot ist aus Abstract von JP 61162011 A bekannt.

Weiterhin ist eine Fassung für Laserfenster aus der GB 2 070 487 bekannt, bei der Fenster und Fassung mit niedrig schmelzendem Lot verlötet werden.

Aufgabe er Erfindung ist die Bereitstellung einer UV-beständigen Fügetechnik hoher Präzision mit geringer Spannungs- und Temperaturbelastung.

Gelöst wird diese Aufgabe durch eine optische Baugruppe nach Anspruch 1, ein optisches System nach Anspruch 6 und ein Verfahren zur Befestigung eines optischen Elements aus nichtmetallischem, insbesondere transparentem Material nach Anspruch 9.

Damit kann dann ein Mikroskop nach Anspruch 7 oder eine Projektionsbelichtungsanlage nach Anspruch 8 bereitgestellt werden.

Vorteilhafte Ausgestaltungen der Erfindung sind Gegenstand der Unteransprüche 2 bis 5 und 10 bis 17.

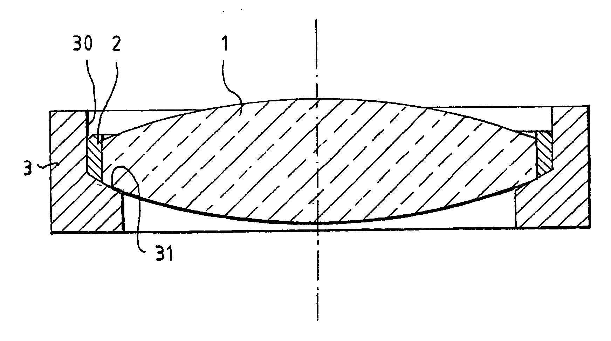

Die erfindungsgemäße Fügetechnik kann also als eine Art Bördelung durch Schmelzen bezeichnet werden. Im Unterschied zum Löten, zum Brazing oder zum Schweißen wird hier ein Näher erläutert wird die Erfindung anhand der Zeichnung. Deren einzige Figur zeigt im schematischen Querschnitt eine Linse 1, die mit einem Ring 2 aus Weichlot in einer Fassung 3 gehalten wird.

Die Fassung 3 wird mit einem größeren Durchmesser für den Linsensitz (Lötspalt 0,1 mm) hergestellt, es ergibt sich also eine ringförmige, einen Spalt bildende Fläche 30 an der Fassung 3. Der Linsensitz (Fläche 30) wird belotet, dabei wird in der Regel (für die Erfindung aber nicht zwingend) eine stoffschlüssige Lötverbindung erzielt. Das Lot 2 hat typisch eine Dicke von 0,1 mm. Der Lotauftrag kann galvanisch erfolgen oder durch klassisches Auftragen aus der Schmelze.

Danach wird der genaue Linsensitz mit einer Spielpassung gefertigt (gedreht), so daß die Linse 1 jetzt richtig positioniert werden kann. Die untere Linsenauflagefläche 31 muß lotfrei sein, um die Lagefixierung zu sichern.

Danach wird die Linse 1 in die Fassung 3 eingelegt und mit der Fassung 3 auf einer Heizplatte erwärmt, bis das Lot 2 schmilzt. Um die Positionierung der Linse 1 sicher zu gewährleisten, kann diese während des Erwärmens auch in einer Vorrichtung geklemmt werden.

Das Lot 2 umschließt den Linsenaußendurchmesser und nach dem Abkühlen sitzt die Linse 1 fest an ihrem Platz, da sich das Lot 2 völlig an den Außenrand der Linse 1 anlegt und geringfügig über den oberen Rand fließt und so eine Art Bördelrand bildet. Das Verfahren führt also zu reinem Formschluß.

Dieses Verfahren eignet sich auch hervorragend zum Fassen von CaF₂, da durch gleichmäßiges Erwärmen keine Temperaturspannungen entstehen können.

Das Material für die Fassung 3 sollte einen ähnlichen Wärmeausdehungskoeffizienten haben wie die Linse 1. Z.B. wird die Linse 1 aus Quarzglas, die Fassung 3 aus Invar (Nickellegierung mit minimaler Wärmeausdehnung) gefertigt. Als Lot 2 wird ein Metall mit einem Schmelzpunkt bei 50-70° C bevorzugt, z.B. die Legierung BiPbSnIn mit Schmelzpunkt 58° C. Je nach Glasart und Einsatzbedingungen können auch höherschmelzende Lote, in der Regel Weichlote, verwendet werden.

Diese Fügetechnik eignet sich besonders für Linsen 1 bis zu wenigen Zentimetern Durchmesser (im Beispiel Durchmesser 20 mm), z.B. in UV-Mikroskopen oder für kleine Linsen in Projektionsbelichtungsanlagen der Mikrolithographie. Genau so können Spiegel - ausgeführt als verspiegelte Glas-, Glaskeramik-, oder Keramikkörper, Prismen und andere optische Elemente an einer Fassung befestigt werden.

Es ist auch vorgesehen, einzelne optische Elemente mit mehreren getrennten Fassungselementen derart mit Lot zu verbinden. Die Fassungselemente können dann durch beliebige (Metall-Metall) Fügetechnik mit weiteren Teilen z.B. zu ringförmigen Fassungsteilen verbunden werden.

## Patentansprüche

1. Optische Baugruppe bestehend aus einem optischen Element (1) aus nichtmetallischem Material, einer Fassung (3) oder einem Fassungselement und einer zwischen optischem Element (1) und Fassung (3) angeordneten Schicht (2) aus einem Lot, **dadurch gekennzeichnet, dass** das Lot aus einem unterhalb von ca. 100° C schmelzenden Metall eine rein formschlüssige Verbindung mit dem optischen Element (1) macht, und dass die Fassung (3) oder das Fassungselement eine untere Auflagefläche (31) hat an der das optische Element (1) direkt anliegt und dass das Lot über den oberen Rand des optischen Elements übersteht und so eine Art Bördelrand bildet.

2. Optische Baugruppe nach Anspruch 1, **dadurch gekennzeichnet, daß** die Schicht (2) eine Dicke der Größenordnung 0,1 mm aufweist.

3. Optische Baugruppe nach mindestens einem der Ansprüche 1 oder 2, **dadurch gekennzeichnet, daß** das optische Element (1) eine Linse ist, vorzugsweise aus Quarzglas oder Kalziumfluorid.

4. Optische Baugruppe nach Anspruch 3, **dadurch gekennzeichnet, daß** die Fassung (3) und auch die Schicht (2) ringförmig sind.

5. Optische Baugruppe nach mindestens einem der Ansprüche 1-4, **dadurch gekennzeichnet, daß** die Fassung (3) oder das Fassungselement hinsichtlich ihrer Wärmeausdehnung an das optische Element (1) angepaßt ist.

6. Optisches System, das mit Licht im Spektralbereich unter 360 nm beaufschlagt ist, **dadurch gekennzeichnet, daß** es mindestens eine Baugruppe nach mindestens einem der Ansprüche 1-5 enthält.

7. Mikroskop mit mindestens einer optischen Baugruppe nach mindestens einem der Ansprüche 1-5.

8. Projektionsbelichtungsanlage der Mikrolithographie mit mindestens einer Baugruppe nach mindestens einem der Ansprüche 1-5.

9. Verfahren zur Befestigung eines optischen Elements (1) aus nichtmetallischem, insbesondere transparentem Material, vorzugsweise aus Quarzglas oder Kalziumfluorid, an einer Fassung (3) oder einem Fassungselement, bei dem die Fassung (3) oder das Fassungselement mit einer mit dem optischen Element (1) einen Spalt bildenden Fläche (30) versehen wird,
- die einen Spalt bildende Fläche (30) mit einem Lot, vorzugsweise einem bei einer Temperatur von unter ca. 100° C schmelzenden Metall (2) beschichtet wird,
- das optische Element (1) an das Metall (2) angelegt wird,
- das Metall (2) geschmolzen wird, so daß sich eine formschlüssige Verbindung mit dem optischen Element (1) ergibt.

10. Verfahren nach Anspruch 9, **dadurch gekennzeichnet, daß** die Fassung (3) oder das Fassungselement auch mit einer Auflagefläche (31) versehen wird und das optische Element (1) an die Auflagefläche (31) angelegt wird

11. Verfahren nach Anspruch 9 oder 10, **dadurch gekennzeichnet, daß** das Lot bzw. das unterhalb von ca. 100° C schmelzende Metall in einer Schicht (2) von größenordnungsmäßig 0,1 mm Dicke auf die Fassung (3) aufgebracht wird.

12. Verfahren nach mindestens einem der Ansprüche 9-11, **dadurch gekennzeichnet, daß** das Lot (2) galvanisch aufgebracht wird.

13. Verfahren nach mindestens einem der Ansprüche 9-12, **dadurch gekennzeichnet, daß** das Lot (2) vor dem Anlegen des optischen Elements (1) spanabhebend, insbesondere durch Drehen, bearbeitet wird.

14. Verfahren nach mindestens einem der Ansprüche 9-13, **dadurch gekennzeichnet, daß** das optische Element (1) beim Schmelzen des Lots (2) mit einer Halterung gegenüber der Fassung (3) fixiert wird.

15. Verfahren nach mindestens einem der Ansprüche 9-14, **dadurch gekennzeichnet, daß** das optische Element (1) eine Linse ist.

16. Verfahren nach mindestens einem der Ansprüche 9-15, **dadurch gekennzeichnet, daß** die einen Spalt bildende Fläche (30) ringförmig ist und das Lot (2) eine ringförmige Schicht bildet.

17. Verfahren nach mindestens einem der Ansprüche 9-16, **dadurch gekennzeichnet, daß** zum Schmelzen des Lots (2) bzw. des Metalls die gesamte optische Baugruppe aus optischem Element (1) und Fassung (3) bzw. Fassungsteil gleichmäßig erwärmt und anschließend abgekühlt wird.

## Claims

1. Optical module comprising an optical element (1) made from non-metallic material, a mount (3) or a mounting element and a layer (2), arranged between the optical element (1) and mount (3), made from a solder, **characterized in that** the solder made from a metal melting below approximately 100°C makes a purely form-fitting connection with the optical element (1), and **in that** the mount (3) or the mounting element has a lower support surface (31) against which the optical element (1) bears directly, and **in that** the solder projects over the upper edge of the optical element and thereby forms a type of flared flange.

2. Optical module according to Claim 1, **characterized in that** the layer (2) has a thickness of the order of magnitude of 0.1 mm.

3. Optical module according to at least either of Claims 1 and 2, **characterized in that** the optical element (1) is a lens, preferably made from silica glass or calcium fluoride.

4. Optical module according to Claim 3, **characterized in that** the mount (3) and also the layer (2) are annular.

5. Optical module according to at least one of Claims 1-4, **characterized in that** the mount (3) or the mounting element is adapted with regard to its thermal expansion to the optical element (1).

6. Optical system in which light in a spectral region below 360 nm is applied, **characterized in that** it includes at least one module according to at least one of Claims 1-5.

7. Microscope having at least one optical module according to at least one of Claims 1-5.

8. Microlithography projection exposure system having at least one module according to at least one of Claims 1-5.

9. Method for fastening an optical element (1) made from non-metallic, in particular transparent material, preferably from silica glass or calcium fluoride, on a mount (3) or a mounting element, in the case of which the mount (3) or the mounting element is provided with a surface (30) forming a gap with the optical element (1),
- the surface (30) forming a gap is coated with a solder, preferably a metal (2) which melts at a temperature of below approximately 100°C,
- the optical element (1) is placed against the metal (2), and
- the metal (2) is melted so that a form-fitting connection with the optical element (1) is produced.

10. Method according to Claim 9, **characterized in that** the mount (3) or the mounting element is also provided with a support surface (31) and the optical element (1) is placed against the support surface (31).

11. Method according to Claim 9 or 10, **characterized in that** the solder or the metal which melts below approximately 100°C is applied to the mount (3) in a layer (2) with a thickness of the order of magnitude of 0.1 mm.

12. Method according to at least one of Claims 9-11, **characterized in that** the solder (2) is galvanically applied.

13. Method according to at least one of Claims 9-12, **characterized in that**, before the optical element (1) is placed on, the solder (2) is machined, in particular by being turned.

14. Method according to at least one of Claims 9-13, **characterized in that** the optical element (1) is fixed in relation to the mount (3) with the aid of a holder during melting of the solder (2).

15. Method according to at least one of Claims 9-14, **characterized in that** the optical element (1) is a lens.

16. Method according to at least one of Claims 9-15, **characterized in that** the surface (30) forming a gap is annular, and the solder (2) forms an annular layer.

17. Method according to at least one of Claims 9-16, **characterized in that** in order to melt the solder (2) or the metal, the entire optical module composed of optical element (1) and mount (3) or the mounting part is uniformly heated and subsequently cooled.

## Revendications

1. Sous-ensemble optique composé d'un élément optique (1) en matériau non métallique, d'une monture (3) ou d'un élément de monture et d'une couche (2) de soudure disposée entre l'élément optique (1) et la monture (3), **caractérisé en ce que** la soudure composée d'un métal qui fond au-dessous de 100 °C environ forme une liaison par simple engagement géométrique avec l'élément optique (1) et que la monture (3) ou l'élément de monture présente une face d'appui inférieure (31) sur laquelle repose directement l'élément optique (1) et que la soudure dépasse au-dessus du bord supérieur de l'élément optique et forme ainsi une espèce de collet rabattu.

2. Sous-ensemble optique selon la revendication 1, **caractérisé en ce que** la couche (2) présente une épaisseur de l'ordre de 0,1 mm.

3. Sous-ensemble optique selon au moins l'une des revendications 1 ou 2, **caractérisé en ce que** l'élément optique (1) est une lentille, de préférence en verre de quartz ou en fluorure de calcium.

4. Sous-ensemble optique selon la revendication 3, **caractérisé en ce que** la monture (3) ainsi que la couche (2) sont en forme d'anneau.

5. Sous-ensemble optique selon au moins l'une des revendications 1 à 4, **caractérisé en ce que** la monture (3) ou l'élément de monture sont adaptés à l'élément optique (1) du point de vue de leur dilatation thermique.

6. Système optique exposé à de la lumière dans la plage spectrale au-dessous de 360 nm, **caractérisé en ce qu'**il contient au moins un sous-ensemble selon au moins l'une des revendications 1 à 5.

7. Microscope comprenant au moins un sous-ensemble optique selon au moins l'une des revendications 1 à 5.

8. Équipement d'éclairage par projection de microlithographie comprenant au moins un sous-ensemble selon au moins l'une des revendications 1 à 5.

9. Procédé de fixation d'un élément optique (1) en matériau non métallique, notamment transparent, de préférence en verre de quartz ou en fluorure de calcium, à une monture (3) ou à un élément de monture, avec lequel la monture (3) ou l'élément de monture est muni d'une surface (30) qui forme une fente avec l'élément optique (30), où
- la surface (30) formant une fente est revêtue d'une soudure, de préférence d'un métal (2) qui fond à une température inférieure à environ 100 °C,
- l'élément optique (1) est appliqué sur le métal (2),
- le métal (2) est fondu de manière à obtenir une liaison par engagement géométrique avec l'élément optique (1).

10. Procédé selon la revendication 9, **caractérisé en ce que** la monture (3) ou l'élément de monture est également doté d'une surface d'appui (31) et l'élément optique (1) est appliqué contre la surface d'appui (31).

11. Procédé selon la revendication 9 ou 10, **caractérisé en ce que** la soudure ou le métal qui fond au-dessous de 100 °C environ est appliqué sur la monture (3) en une couche (2) dont l'épaisseur est de l'ordre de 0,1 mm.

12. Procédé selon au moins l'une des revendications 9 à 11, **caractérisé en ce que** la soudure (2) est appliqué de manière galvanique.

13. Procédé selon au moins l'une des revendications 9 à 12, **caractérisé en ce que** la soudure (2) est usiné par enlèvement de copeaux, notamment par tournage avant l'application de l'élément optique (1).

14. Procédé selon au moins l'une des revendications 9 à 13, **caractérisé en ce que** l'élément optique (1) est fixé avec une attache par rapport à la monture (3) lors de la fusion de la soudure (2).

15. Procédé selon au moins l'une des revendications 9 à 14, **caractérisé en ce que** l'élément optique (1) est une lentille.

16. Procédé selon au moins l'une des revendications 9 à 15, **caractérisé en ce que** la surface (30) formant une fente est en forme d'anneau et la soudure (2) forme une couche en forme d'anneau.

17. Procédé selon au moins l'une des revendications 9 à 16, **caractérisé en ce que** l'ensemble du sous-ensemble optique composé de l'élément optique (1) et de la monture (3) ou de l'élément de monture est réchauffé de manière homogène et ensuite refroidi en vue de la fusion de la soudure (2), respectivement du métal.
